# EUROPEAN PATENT SPECIFICATION

(11) **EP 3 056 585 B1**
(45) Date of publication and mention of the grant of the patent: **04.04.2018**
(21) Application number: 16154789.8
(22) Date of filing: 09.02.2016
(51) Int. Cl.: C23C 14/32, C23C 14/02, C23C 14/58, C23C 14/16, C23C 14/06, C23C 14/34, C23C 14/35, H01F 1/057, H01F 41/02

(54) **A METHOD OF DISPOSING AN ALUMINUM COATING ON ND-FE-B PERMANENT MAGNETS**
VERFAHREN ZUR BESEITIGUNG EINER ALUMINIUMBESCHICHTUNG AUF ND-FE-B-PERMANENTMAGNETEN
PROCÉDÉ D'ÉLIMINATION D'UN REVÊTEMENT EN ALUMINIUM SUR AIMANTS PERMANENTS ND-FE-B

(30) Priority: 12.02.2015 CN 201510078215
(43) Date of publication of application: 17.08.2016
(73) Proprietor: Yantai Shougang Magnetic Materials Inc., 265500 Yantai (CN)
(72) Inventor: Jia, Daoning, 265500 Yantai City (CN); Peng, Zhongjie, 265500 Yantai City (CN); Yang, Kunkun, 265500 Yantai City (CN)
(74) Representative: Gulde & Partner

(56) References cited:
- JP-A- 2000 232 011

## Description

The present invention deals about a surface treatment technology of Nd-Fe-B permanent magnets. More specifically, the invention relates to a new method for disposing an aluminum coating on Nd-Fe-B permanent magnets.

### Technical Background

Nd-Fe-B permanent magnets in damp environment easily rust because of containing a large amount of rare earth metals. In order to prevent rusting, it is generally known to dispose an anti-corrosion layer on the Nd-Fe-B permanent magnets surface by electroplating.

The technology of multi-arc ion coating has gained rapid development in the recent years, a variety of equipment have been developed and put into use. Multi-arc ion plating technology is an improved method of ion plating and it is a kind of surface coating technology that uses electric arc as the power of vaporizing (said equipment for multi-arc ion plating will be referred to as multi-arc sputtering equipment' in the following). Because the melting point of aluminum is very low, the coating became rough when the chamber of the multi-arc equipment remain high temperature, consequently, it would be favourable to lower temperature and further to reduce the aluminum particle cluster.

JP 2000-23211 A refers to Fe-Br-R permanent magnets with a corrosion-resistant metal oxide film, especially Al oxide film. The metal oxide film is disposed on the magnets by an arc deposition process.

### Summary of Invention

The invention overcomes the shortage of the existing technologies and provides a new kind of aluminum coating for Nd-Fe-B permanent magnets.

According to the present invention there is provided a method for disposing an aluminum coating on Nd-Fe-B permanent magnets. The method includes the steps of:
a) Performing a pre-treatment of the Nd-Fe-B permanent magnets;
b) Fixing the Nd-Fe-B permanent magnets on a jig and placing the same in a multi-arc sputtering equipment;
c) Evacuating the multi-arc sputtering equipment with a vacuum system until the pressure reaches 1×10⁻²Pa to 3×10⁻²Pa, then introducing argon gas until the pressure reaches 1×10⁻¹Pa to 5×10⁻¹Pa, starting bias voltage treatment of the Nd-Fe-B permanent magnets for 1 to 10 minutes at 800V to 1000V;
d) Stopping bias voltage treatment and then evacuating the multi-arc sputtering equipment until the pressure reaches 1×10⁻³Pa to 8×10⁻³Pa, then refilling argon gas until the pressure reaches 3×10⁻¹Pa to 5×10⁻¹Pa, then starting arc deposition from a target source and maintain a DC current between 50A to 70A, turn on bias voltage and maintain voltage between 100V to 200V, and maintain coating the magnets for 0.5 to 5h;
e) Cooling down on 20°C to 100°C and taking out the Nd-Fe-B permanent magnets from the multi-arc sputtering equipment; and
f) Dipping the Nd-Fe-B permanent magnets into a passivating agent for 1 to 20 minutes and then rinse with water.

The Nd-Fe-B permanent magnets used for the present coating process may be preferably sintered Nd-Fe-B permanent magnets or heavy rare earth element diffusion Nd-Fe-B permanent magnets. The heavy rare earth elements may preferably contain Tb or Dy.

Preferably, step a) of pre-treatment of the Nd-Fe-B permanent magnets includes degreasing the surfaces of the magnets with a degreasing fluid, then washing the surfaces with nitric acid having a concentration of 3% to 5%, washing the surfaces with deionized water, optionally applying a soot detergent, and finally blowing-drying of the magnets. Prior to step b), the pre-treated Nd-Fe-B permanent magnets may be again dried in a drying oven.

In step b), water having a temperature of 0°C to 5°C may be used for cooling the multi-arc target in order to prevent big droplet spatter. The Nd-Fe-B permanent magnets placed on the jig may revolve on the jig axis as well as the jig may revolve on axis of the multi-arc sputtering equipment.

The target source of the multi-arc sputtering equipment may be an aluminum target source.

Preferably, a N50 grade permanent magnet is placed at the back of the target to control arc rotation within the multi-arc sputtering equipment and adjust a distance between the N50 permanent magnet and the aluminum target to be 1cm to 10cm. Hence, the N50 permanent magnet allows controlling the arc rotation and may thus increase the coating efficiency and accelerate the velocity of the arc.

According to another preferred embodiment, the argon gas used in step c) has a purity of more than 99.7%.

According to another preferred embodiment, the aluminum coating has a thickness of 2 to 40µm.

According to another preferred embodiment, a concentration range of the passivating agent varies from 15% to 25% (aqueous solution).

### Mode of Carrying out the Invention

The present invention will now be described in exemplary embodiments.

### Example 1 - General Description of the Manufacturing Process

a) Degreasing surfaces of the Nd-Fe-B permanent magnets by degreasing fluid, then washing by nitric acid of concentration 4%, deionized water, soot detergent; and finally blowing-dry the Nd-Fe-B permanent magnets.
b) Drying again the Nd-Fe-B permanent magnets at 55°C for 30min in a drying oven, then fixing the Nd-Fe-B permanent magnets on a jig, placing that in a multi-arc sputtering equipment, running the equipment, access 3°C water to cool the multi-arc target, the Nd-Fe-B permanent magnets will be rotating and revolving in the multi-arc sputtering equipment. Employ N50 permanent magnet to control arc rotating within the multi-arc sputtering equipment and adjust the distance between the N50 permanent magnet and aluminum targets to be 5 cm to accelerate the velocity of arc.
c) Pumping via a vacuuming system until the multi-arc sputtering equipment vacuum reaches 2×10⁻²Pa, then filling argon gas with mass percentage of 99.8% until the vacuum reaches 2×10⁻¹Pa, start bias voltage to clean Nd-Fe-B permanent magnets for 5 minutes at 900V.
d) Switching off bias voltage and turn off argon gas filling until the multi-arc sputtering equipment vacuum reaches 6×10⁻³Pa by vacuuming system, refilling the argon gas until the vacuum is 4×10⁻¹Pa, then switching on the power for the target source and maintaining the DC current at 60A, turn on bias voltage and maintaining the same at 150V, coating the magnets for 1.5h until the aluminum film thickness is 10µm.
e) After coating, opening the door of the multi-arc sputtering equipment, when cooled down to 80°C, take out the Nd-Fe-B permanent magnets from the multi-arc sputtering equipment.
f) Dipping the Nd-Fe-B permanent magnets into a passivating agent whose concentration is 20% for 8 minutes and then rinse with water.

### Example 2 - Specific Example

a) Degreasing surfaces of the Nd-Fe-B permanent magnets by degreasing fluid, then washing by nitric acid of concentration 3%, deionized water, soot detergent; and finally blowing-dry the Nd-Fe-B permanent magnets.
b) Drying again the Nd-Fe-B permanent magnets at 50°C for 30min in a drying oven, then fixing the Nd-Fe-B permanent magnets on a jig, placing that in a multi-arc sputtering equipment, running the equipment, access 0°C water to cool the multi-arc target, the Nd-Fe-B permanent magnets will be rotating and revolving in the multi-arc sputtering equipment. Employ N50 permanent magnet to control arc rotating within the multi-arc sputtering equipment and adjust the distance between the N50 permanent magnet and aluminum targets to be 1 cm to accelerate the velocity of arc.
c) Pumping via a vacuuming system until the multi-arc sputtering equipment vacuum reaches 1×10⁻²Pa, then filling argon gas with mass percentage of 99.7% until the vacuum reaches 1×10⁻¹Pa, start bias voltage to clean Nd-Fe-B permanent magnets for 1 minute at 800V.
d) Switching off bias voltage and turn off argon gas filling until the multi-arc sputtering equipment vacuum reaches 1×10⁻³Pa by vacuuming system, refilling the argon gas until the vacuum is 3×10⁻¹Pa, then switching on the power for the target source and maintaining the DC current at 50A, turn on bias voltage and maintaining the same at 100V, coating the magnets for 0.5h until the aluminum film thickness is 2µm.
e) After coating, opening the door of the multi-arc sputtering equipment, when cooled down to 20°C, take out the Nd-Fe-B permanent magnets from the multi-arc sputtering equipment.
f) Dipping the Nd-Fe-B permanent magnets into passivating agent whose concentration is 25% for 1 minutes and then rinse with water.

### Example 3 - Specific Example

a) Degreasing surfaces of the Nd-Fe-B permanent magnets by degreasing fluid, then washing by nitric acid of concentration 5%, deionized water, soot detergent; and finally blowing-dry the Nd-Fe-B permanent magnets.
b) Drying again the Nd-Fe-B permanent magnets at 60°C for 30min in a drying oven, then fixing the Nd-Fe-B permanent magnets on a jig, placing that in a multi-arc sputtering equipment, running the equipment, access 5°C water to cool the multi-arc target, the Nd-Fe-B permanent magnets will be rotating and revolving in the multi-arc sputtering equipment. Employ N50 permanent magnet to control arc rotating within the multi-arc sputtering equipment and adjust the distance between the N50 permanent magnet and aluminum targets to be 10 cm to accelerate the velocity of arc.
c) Pumping via a vacuuming system until the multi-arc sputtering equipment vacuum reaches 1×10⁻²Pa, then filling argon gas with mass percentage of 99.9% until the vacuum reaches 1×10⁻¹Pa, start bias voltage to clean Nd-Fe-B permanent magnets for 1 minute at 800V.
d) Switching off bias voltage and turn off argon gas filling until the multi-arc sputtering equipment vacuum reaches 3×10⁻³Pa by vacuuming system, refilling the argon gas until the vacuum is 5×10⁻¹Pa, then switching on the power for the target source and maintaining the DC current at 70A, turn on bias voltage and maintaining the same at 200V, coating the magnets for 5h until the aluminum film thickness is 40µm.
e) After coating, opening the door of the multi-arc sputtering equipment, when cooled down to 100°C, unload the Nd-Fe-B permanent magnets from the multi-arc sputtering equipment.
f) Dipping the Nd-Fe-B permanent magnets into a passivating agent whose concentration is 15% for 20 minutes and then rinse with water.

Salt spray test (SST) were made according to ISO 9227-9227 standard.

Shear force test were made according to ISO 4624-2003 standard.

| | thickness | appearance | shear force | SST |
|---|---|---|---|---|
| Example 1 | 10µm | smooth | 31Mpa | 300H |
| | | | | |

| | | | | |
|---|---|---|---|---|
| | thickness | appearance | shear force | SST |
| Example 2 | 2µm | smooth | 33Mpa | 120H |
| | | | | |

| | thickness | appearance | shear force | SST |
|---|---|---|---|---|
| Example 3 | 40µm | smooth | 33Mpa | 960H |
| | | | | |

## Claims

1. A method for disposing an aluminum coating on Nd-Fe-B permanent magnets, the method including the steps of:
a) Performing a pre-treatment of the Nd-Fe-B permanent magnets;
b) Fixing the Nd-Fe-B permanent magnets on a jig and placing the same in a multi-arc sputtering equipment;
c) Evacuating the multi-arc sputtering equipment with a vacuum system until the pressure reaches 1×10⁻²Pa to 3×10⁻²Pa, then introducing argon gas until the pressure reaches 1×10⁻¹Pa to 5×10⁻¹Pa, starting bias voltage treatment of the Nd-Fe-B permanent magnets for 1 to 10 minutes at 800V to 1000V;
d) Stopping bias voltage treatment and then evacuating the multi-arc sputtering equipment until the pressure reaches 1×10⁻³Pa to 8×10⁻³Pa, then refilling argon gas until the pressure reaches 3×10⁻¹Pa to 5×10⁻¹Pa, then starting arc deposition from a target source and maintain a DC current between 50A to 70A, turn on bias voltage and maintain voltage between 100V to 200V, and maintain coating the magnets for 0.5 to 5h;
e) Cooling down on 20°C to 100°C and taking out the Nd-Fe-B permanent magnets from the multi-arc sputtering equipment; and
f) Dipping the Nd-Fe-B permanent magnets into a passivating agent for 1 to 20 minutes and then rinse with water.

2. The method of claim 1, wherein the Nd-Fe-B permanent magnets are sintered Nd-Fe-B permanent magnets or heavy rare earth element diffusion Nd-Fe-B permanent magnets.

3. The method of claim 1, wherein step a) of pre-treatment of the Nd-Fe-B permanent magnets includes degreasing the surfaces of the magnets with a degreasing fluid, then washing the surfaces with nitric acid having a concentration of 3% to 5%, washing the surfaces with deionized water, and finally blowing-drying of the magnets.

4. The method of claim 1, wherein in step b) water having a temperature of 0°C to 5°C is used for cooling the multi-arc target.

5. The method of claim 1, wherein the target source of the multi-arc sputtering equipment is an aluminum target source.

6. The method of claim 1, wherein a N50 grade permanent magnet is placed at the back of the target to control arc rotation within the multi-arc sputtering equipment and adjust a distance between the N50 permanent magnet and the aluminum target to be 1cm to 10cm.

7. The method of claim 1, wherein the argon gas used in step c) has a purity of more than 99.7%.

8. The method of claim 1, wherein the aluminum coating has a thickness of 2 to 40µm.

9. The method of claim 1, wherein a concentration range of the passivating agent varies from 15% to 25%.

## Patentansprüche

1. Verfahren zum Aufbringen einer Aluminiumbeschichtung auf Nd-Fe-B-Permanentmagnete, wobei das Verfahren die folgenden Schritte umfasst:
a) Durchführung einer Vorbehandlung der Nd-Fe-B-Permanentmagnete;
b) Befestigen der Nd-Fe-B-Permanentmagnete an einer Spannvorrichtung und Platzieren derselben in einer Mehrfachlichtbogen-Sputtereinrichtung;
c) Evakuieren der Mehrfachlichtbogen-Sputtereinrichtung mit einem Vakuumsystem, bis der Druck 1 × 10⁻² Pa bis 3 × 10⁻² Pa erreicht, anschließend Einleiten von Argongas, bis der Druck 1 × 10⁻¹ Pa bis 5 × 10⁻¹ Pa erreicht, Beginnen der Vorspannungsbehandlung der Nd-Fe-B-Permanentmagnete für 1 bis 10 Minuten bei 800 V bis 1.000 V;
d) Stoppen der Vorspannungsbehandlung und anschließend Evakuieren der Mehrfachlichtbogen-Sputtereinrichtung, bis der Druck 1 × 10⁻³ Pa bis 8 × 10⁻³ Pa erreicht, anschließend Wiederauffüllen von Argongas, bis der Druck 3 × 10⁻¹ Pa bis 5 × 10⁻¹ Pa erreicht, anschließend Starten der Lichtbogenabscheidung von einer Zielquelle und Aufrechterhalten eines Gleichstroms zwischen 50 A bis 70 A, Anschalten der Vorspannung und Aufrechterhalten der Spannung zwischen 100 V bis 200 V und Halten der Beschichtung der Magneten für 0,5 bis 5 Stunden;
e) Abkühlen auf 20 °C bis 100 °C und Herausnehmen der Nd-Fe-B-Permanentmagnete aus der Mehrfachlichtbogen-Sputtereinrichtung; und
f) Eintauchen der Nd-Fe-B-Permanentmagnete in ein Passivierungsmittel für 1 bis 20 Minuten und anschließendes Spülen mit Wasser.

2. Verfahren nach Anspruch 1, wobei die Nd-Fe-B-Permanentmagnete gesinterte Nd-Fe-B-Permanentmagnete oder schwere Nd-Fe-B-Dauermagnetmagnete mit Seltenerdelement-Diffusionsbeschichtung sind.

3. Verfahren nach Anspruch 1, wobei der Schritt a) der Vorbehandlung der Nd-Fe-B-Permanentmagnete das Entfetten der Oberflächen der Magnete mit einer Entfettungsflüssigkeit und das anschließende Waschen der Oberflächen mit Salpetersäure mit einer Konzentration von 3 % bis 5 %, das Waschen der Oberflächen mit deionisiertem Wasser und schließlich Trockenblasen der Magnete umfasst.

4. Verfahren nach Anspruch 1, wobei in Schritt b) Wasser mit einer Temperatur von 0 °C bis 5 °C zum Kühlen des Mehrfachlichtbogen-Ziels verwendet wird.

5. Verfahren nach Anspruch 1, wobei die Zielquelle der Mehrfachlichtbogen-Sputtereinrichtung eine Aluminium-Zielquelle ist.

6. Verfahren nach Anspruch 1, wobei ein Permanentmagnet der Güte N50 an der Rückseite des Ziels angeordnet ist, um die Lichtbogenrotation innerhalb der Mehrfachlichtbogen-Sputtereinrichtung zu steuern und einen Abstand zwischen dem N50-Permanentmagneten und dem Aluminiumziel von 1 cm bis 10 cm einzustellen.

7. Verfahren nach Anspruch 1, wobei das in Schritt c) verwendete Argongas eine Reinheit von mehr als 99,7 % aufweist.

8. Verfahren nach Anspruch 1, wobei die Aluminiumbeschichtung eine Dicke von 2 bis 40 µm aufweist.

9. Verfahren nach Anspruch 1, wobei ein Konzentrationsbereich des Passivierungsmittels von 15 % bis 25 % variiert.

## Revendications

1. Procédé d'élimination d'un revêtement en aluminium sur des aimants permanents à base de Nd-Fe-B, le procédé comprenant les étapes consistant à :
a) Effectuer un prétraitement des aimants permanents à base de Nd-Fe-B ;
b) Fixer les aimants permanents à base de Nd-Fe-B sur un gabarit et les placer dans un équipement de pulvérisation à arcs multiples ;
c) Évacuer l'équipement de pulvérisation à arcs multiples avec un système sous vide jusqu'à ce que la pression atteigne une pression comprise entre 1x10⁻² Pa et 3x10⁻² Pa, ensuite introduire de l'argon gazeux jusqu'à ce que la pression atteigne une pression comprise entre 1x10⁻¹ Pa et 5x10⁻¹ Pa, commencer un traitement par tension de polarisation des aimants permanents à base de Nd-Fe-B pendant 1 à 10 minutes entre 800 V et 1000 V;
d) Arrêter le traitement par tension de polarisation et ensuite évacuer l'équipement de pulvérisation à arcs multiples jusqu'à ce que la pression atteigne une pression comprise entre 1x10⁻³ Pa et 8x10⁻³ Pa, ensuite remplir l'argon gazeux jusqu'à ce que la pression atteigne une pression comprise entre 3x10⁻¹ Pa et 5x10⁻¹ Pa, ensuite commencer un dépôt à arcs à partir d'une source cible et maintenir un courant continu compris entre 50 A et 70 A, allumer la tension de polarisation et maintenir une tension comprise entre 100 V et 200 V, et maintenir le revêtement des aimants de 0,5 à 5 h ;
e) Refroidir entre 20° C 100° C et retirer les éléments permanents à base de Nd-Fe-B de l'équipement de pulvérisation à arcs multiples ; et
f) Tremper les aimants permanents à base de Nd-Fe-B dans un agent de passivation pendant 1 à 20 minutes et ensuite rincer avec de l'eau.

2. Procédé selon la revendication 1, dans lequel les aimants permanents à base de Nd-Fe-B sont des aimants permanents à base de Nd-Fe-B frittés ou des aimants permanents à base de Nd-Fe-B à diffusion d'éléments de terres rares lourdes.

3. Procédé selon la revendication 1, dans lequel l'étape a) de prétraitement des aimants permanents à base de Nd-Fe-B consiste à dégraisser les surfaces des aimants à l'aide d'un fluide de dégraissage, ensuite laver les surfaces avec de l'acide nitrique possédant une concentration comprise entre 3 % et 5 %, laver les surfaces avec de l'eau désionisée, et finalement sécher les aimants par soufflage.

4. Procédé selon la revendication 1, dans lequel dans l'étape b) de l'eau possédant une température comprise entre 0 °C et 5 °C est utilisée pour refroidir la cible à plusieurs arcs.

5. Procédé selon la revendication 1, dans lequel la source cible de l'équipement de pulvérisation à arcs multiples consiste en une source cible en aluminium.

6. Procédé selon la revendication 1, dans lequel un aimant permanent de type N50 est placé à l'arrière de la cible pour commander la rotation d'arc à l'intérieur de l'équipement de pulvérisation à arcs multiples et pour ajuster une distance entre l'élément permanent N50 et la cible en aluminium qui soit comprise entre 1 cm et 10 cm.

7. Procédé selon la revendication 1, dans lequel l'argon gazeux utilisé lors de l'étape c) possède une pureté de plus de 99,7 %.

8. Procédé selon la revendication 1, dans lequel le revêtement en aluminium possède une épaisseur comprise entre 2 et 40 µm.

9. Procédé selon la revendication 1, dans lequel une gamme de concentration de l'agent de passivation varie entre 15 % et 20 %.
